# EUROPÄISCHE PATENTSCHRIFT

(11) **EP 0 569 423 B1**
(45) Veröffentlichungstag und Bekanntmachung des Hinweises auf die Patenterteilung: **06.08.1997**
(21) Anmeldenummer: 92903608.5
(22) Anmeldetag: 31.01.1992
(51) Int. Cl.: H05K 3/34, B23K 3/04

(54) **VERFAHREN ZUM LÖTEN VON LÖTGUT, WIE LEITERPLATTEN BZW. BAUGRUPPEN IN DER ELEKTRONIK ODER METALLEN IN DER MECHANISCHEN FERTIGUNG**
PROCESS FOR SOLDERING MATERIALS LIKE PRINTED CIRCUIT BOARDS OR SETS OF COMPONENTS IN ELECTRONICS OR METALS IN ENGINEERING WORK
PROCEDE DE SOUDAGE DE PIECES A SOUDER, TELLES QUE PLAQUETTES DE CIRCUITS IMPRIMES OU COMPOSANTS ELECTRONIQUES OU METAUX DANS LA FABRICATION MECANIQUE

(30) Priorität: 01.02.1991 DE 4103098
(43) Veröffentlichungstag der Anmeldung: 18.11.1993
(73) Patentinhaber: LEICHT, Helmut, Walter, D-86343 Königsbrunn (DE)
(72) Erfinder: LEICHT, Helmut, Walter, D-86343 Königsbrunn (DE)
(74) Vertreter: VOSSIUS & PARTNER
(86) Internationale Anmeldenummer: EP9200213
(87) Internationale Veröffentlichungsnummer: WO9214347

(56) Entgegenhaltungen:
- DE-A- 3 915 040
- US-A- 4 453 916
- PATENT ABSTRACTS OF JAPAN, Bd 11, Nr. 76 (M-569)(2523) 7. März 1987;& JP-A-61232058

## Beschreibung

Die Erfindung betrifft ein Verfahren zum Löten von Lötgut, wie Leiterplatten bzw. Baugruppen in der Elektronik oder Metallen in der mechanischen Fertigung. Derartige Verfahren bewirken eine feste Verbindung von Lötgut mittels Lot, wobei dieses vorher verflüssigt werden muß.

Aus der DE-OS 39 15 040 ist es bekannt, vor dem eigentlichen Dampfphasen-Löten das Lötgut durch Besprühen mit einer Flüssigkeit vorzuwärmen. Aus der DE-AS 10 81 088 ist es bekannt, nach dem Lötvorgang die Lötstelle mit Hilfe eines Dampfstrahls thermisch nachzubehandeln. Das eigentliche Löten erfolgt jedoch in üblicher Weise durch Schwallöten oder durch übliches Aufschmelzen, wie IR-Löten, durch Heißluft oder durch Dampfphasen-Löten. Aus der JP-A-61-232 058 ist ein Lötverfahren bekannt, bei dem die zum Löten erforderliche Warme mittels einer erwärmten Flüssigkeit der Lötstelle durch Sprühen zugeführt wird. Bekannte Lötverfahren sind das Schwallöten, wobei bereits verflüssigtes Lot der Lötstelle zugeführt wird, und verschiedene Aufschmelzlötverfahren, bei denen das an der Lötstelle bereits vorher aufgebrachte Lot zum Herstellen der Lötverbindung aufgeschmolzen wird. Beispiele für derartige Aufschmelzlötverfahren sind das IR-Löten, wobei eine Lotverflüssigung durch Infrarotstrahlung erfolgt; das Bügel löten, wobei eine Kontaktwärmeübertragung erfolgt; das Heißluftlöten, wobei eine Wärmeübertragung durch Konvektion erfolgt; und das Dampfphasenlöten, wobei die Wärme durch Kondensation des Dampfes auf der Lötstelle übertragen wird.

Bei den bekannten Lötverfahren ist es schwierig, eine thermische Überlastung des Lötgutes zu vermeiden. Ein optimales Verfahren sollte die Temperatur des Lötgutes möglichst niedrig halten, also nur dicht oberhalb des Schmelzpunktes des Lotes arbeiten. Bei den bekannten Lötverfahren besteht im allgemeinen eine Temperaturdifferenz zwischen dem Wärme übertragenden Medium und dem Schmelzpunkt des Lotes von mindestens 30°C. Diese Differenz ist erforderlich, um unter Berücksichtigung der Wärmeübertragung in einem produktionsgerechten Zeitraum eine sichere Lötung zu gewährleisten. Außerdem läßt sich bei den genannten Verfahren die Temperatur während der Wärmeübertragung nicht sehr genau einstellen oder in kleinen Intervallen verändern.

Bei einem anderen bekannten Verfahren zum Verzinnen von Leiterplatten wird nach dem Verzinnen das überschüssige Lot mittels einer heißen Flüssigkeit z.B. Öl entfernt. Ein solches Verfahren ist unter der Bezeichnung "Hot Oil Leveling" bekannt. Dabei wird heißes Öl unter Druck auf die Leiterplatte gesprüht. Das Öl schmilzt überschüssiges Lot auf, ebnet die Lötstelle ein und entfernt restliches Lot. Im Anschluß muß das Öl durch eine Reinigung von der Leiterplatte entfernt werden. Das Verfahren ist für den Lötvorgang selbst nicht verwendbar.

Aus der JP-A-61-232 058 ist ein Lötverfahren bekannt, bei dem die zum Löten erforderliche Warme teilweise mittels einer erwarmten Flüssigkeit der Lötstelle durch Spruhen zugeführt wird.

Demgegenüber liegt der Erfindung die Aufgabe zugrunde, ein Verfahren zum Löten von Lötgut, wie Leiterplatten bzw. Baugruppen in der Elektronik oder von Metallen in der mechanischen Fertigung, zur Verfügung zu stellen, wobei eine geringe Temperaturbelastung des Lötgutes, eine genau und variabel einstellbare Wärmeübertragung und eine saubere und kostengünstige Prozeßführung erreicht wird.

Diese Aufgabe wird mit den Merkmalen der Patentansprüche gelöst.

Bei der Lösung geht die Erfindung von dem Grundgedanken aus, durch Aufbringen einer geeignet erwärmten Flüssigkeit die Temperatur der Lötstelle so einzustellen, daß deren Temperatur bei oder dicht über dem Schmelzpunkt des Lotes liegt, wobei die Flüssigkeit auch in Zwischenräume dringt und durch gute Wärmeübertragung ihre Wärme in kurzer Zeit an die Lötstelle abgibt.

Die Vorteile der Erfindung sind: die Temperatur der Flüssigkeit kann sehr genau gesteuert werden, und es lassen sich damit - und gegebenenfalls zusätzlich durch geeignete Mengensteuerung der zugeführten Flüssigkeit - beliebige Lötprofile einstellen; es läßt sich ein sehr sanfter Temperaturanstieg realisieren, der eine größtmögliche Schonung elektronischer Bauelemente gewährleistet; durch eine gleichmäßige Verteilung der Flüssigkeit auf der Oberfläche des Lötgutes wird eine äußerst gleichmäßige Wärmeübertragung gewährleistet; und es ist nur eine geringe Temperaturdifferenz (<10°C) zwischen der höheren Temperatur der Flüssigkeit und dem Schmelzpunkt des Lotes erforderlich.

Bei dem erfindungsgemäßen Verfahren kommt die Lötgutoberfläche mit der erwärmten Flüssigkeit in Kontakt. Das Lötgut kann aus verschiedenen Bauteilen in der Elektronik oder in der mechanischen Fertigung bestehen, die miteinander durch Lot verbunden werden sollen. Dieses befindet sich in fester Form oder als Lotpaste in der Nähe der zu lötenden Teile, oder es kann in flüssiger Form, z.B. durch einen Lotschwall zugeführt werden.

Im letzteren Fall wird das Lötgut durch die erwärmte Flüssigkeit aufgeheizt, so daß nur eine geringe Wärmeableitung aus dem Schwallot auftritt. Auf diese Weise läßt sich durch das erfindungsgemäße Verfahren eine Reduzierung der Temperatur des Schwallotes von 240 bis 260°C auf bis zu 190°C erreichen, wobei die Temperaturbelastung der Baugruppe gesenkt wird.

Bei festem oder pastösem Lot wird die zum Schmelzen des Lotes erforderliche Wärme durch die Flüssigkeit übertragen. Dieser Vorgang ist aufgrund des guten Wärmeübergangs und der guten Kriechfähigkeit von Flüssigkeiten sehr kurzfristig und erfordert gegenüber dem Schmelzpunkt des Lotes nur eine geringe Übertemperatur der Flüssigkeit.

Nach der Beendigung des Lötvorgangs verdampft die Restflüssigkeit infolge der Restwärme des Lötgutes. Vorteilhaft ist jedoch eine nachträgliche Trocknung des Lötgutes z.B. durch Warmluftgebläse.

Das erfindungsgemäße Verfahren verwendet chemisch inerte, insbesondere nicht oxidierende oder reduzierende Flüssigkeiten, die auch bei den hier relevanten Temperaturen chemisch stabil sind, also sich nicht zersetzen. Durch die Benetzung der Lötstelle bildet sich ein Schutzfilm, der eine Oxidation während des Lötvorgangs verhindert und so den Einsatz milder und feststoffarmer Flußmittel ermöglicht.

Die variable Temperaturführung des erfindungsgemäßen Verfahrens erlaubt die Verarbeitung von hoch- bis niedrig-schmelzenden Loten. Die bei der Erwärmung entstehenden Temperaturgradienten können extrem gut gesteuert werden. Durch Variation der Flüssigkeitstemperatur lassen sich z.B. Temperaturgradienten zwischen 0,3°C sec⁻¹ und 15°C sec⁻¹ einstellen. Kleine Temperaturgradienten sind besonders für die Elektronikindustrie vorteilhaft, da eine schnelle Erwärmung zur Schädigung empfindlicher Bauelemente führt. Durch eine Temperatursteuerung der Flüssigkeit während des Aufheizprozesses des Lotes können beliebige Temperaturprofile eingestellt und für jeden Fall optimale Bedingungen geschaffen werden.

Das Verfahren ist in weiten Bereichen frei steuerbar und kann sowohl im kontinuierlichen als auch im diskontinuierlichen Betrieb arbeiten. Der Flüssigkeitsdurchsatz ist unterschiedlich, entsprechend der Art des Lötgutes, z.B. elektronische Baugruppen oder metallische mechanische Teile. Die Menge der zugeführten Flüssigkeit kann so gesteuert werden, daß vorwiegend nur die sich aus der Wärmekapazität der Lötstellen ergebende erforderliche Wärmemenge auf das Lötgut übertragen wird und somit eine Erwärmung der Bauelemente stark eingeschränkt wird. Außerdem kann das Lötgut extern (außerhalb der Lötanlage) vorgeheizt und das Verfahren in einer oder mehreren Arbeitsstationen durchgeführt werden.

Im folgenden soll das erfindungsgemäße Verfahren durch einige Beispiele dargestellt werden.

### Beispiel 1

### Löten von Metallteilen bei fest eingestellter Flüssigkeitstemperatur

Metallteile sind unempfindlich gegen schnelle Erwärmung und können deshalb mit großen Temperaturgradienten erwärmt werden.

Das Lötgut
1. wird extern nicht vorgeheizt,
2. fährt in die Lötanlage,
3. erreicht die Lötkammer mit einer Temperatur von 23°C,
4. wird 20 Sekunden mit heißer Flüssigkeit benetzt (Flüssigkeitstemperatur 220°C), dabei kommt es zu einem steilen Temperaturanstieg,
5. erwärmt sich auf Löttemperatur, der Lötvorgang findet statt (ab 183°C) ,
6. verläßt die Lötkammer mit einer Temperatur von ca. 210°C,
7. fährt in die Trockenkammer der Lötanlage (Umluft), und
8. verläßt die Lötanlage in trockenem Zustand.

### Beispiel 2

### Löten von Metallteilen bei fest eingestellter Flüssigkeitstemperatur mit Vorheizen in der Lötanlage

Das Lötgut
1. wird extern nicht vorgeheizt,
2. fährt in die Lötanlage, wird in der Erwärmungskammer 10 Sekunden mit 130°C warmer Flüssigkeit benetzt, es kommt zu einem steilen Temperaturanstieg, das Lötgut heizt sich dabei auf ca. 125°C auf,
3. fährt in die Lötkammer mit einer Temperatur von 121°C,
4. wird 10 Sekunden mit Flüssigkeit benetzt (Flüssigkeitstemperatur 210°C), es kommt zu einem steilen Temperaturanstieg,
5. das Lötgut erwärmt sich auf ca. 208°C, der Lötvorgang findet statt (ab 183°C),
6. verläßt die Lötkammer mit einer Temperatur von ca. 202°C,
7. fährt in die Trockenkammer der Lötanlage (Umluft), und
8. verläßt die Lötanlage in trockenem Zustand.

### Beispiel 3

### Löten einer elektronischen Baugruppe bei sich verändernder Flüssigkeitstemperatur mit externer Vorheizung

Elektronische Baugruppen sind durch die zu verarbeitenden Bauelemente während der Erwärmung auf Löttemperatur empfindlich gegen große Temperaturgradienten, daher erfolgt die Erwärmung mit kleinem Temperaturgradienten.

Die Baugruppe
1. wird extern auf ca. 120°C vorgeheizt,
2. fährt in die Lötanlage,
3. erreicht die Lötkammer mit einer Temperatur von 103°C,
4. wird 20 Sekunden mit Flüssigkeit benetzt, wobei die Flüssigkeitstemperatur während des Benetzungsvorganges von 110°C auf 200°C ansteigt,
5. erwärmt sich, der Lötvorgang findet statt (ab 183°C),
6. verläßt die Lötkammer mit einer Temperatur von ca. 195°C,
7. fährt in die Trockenkammer der Lötanlage (Umluft), und
8. verläßt die Lötanlage in trockenem Zustand.

### Beispiel 4

### Löten einer elektronischen Baugruppe bei sich verändernder Flüssigkeitstemperatur ohne externe Vorheizung

Die Baugruppe
1. wird extern nicht vorgeheizt,
2. fährt in die Lötkammer der Lötanlage,
3. wird 10 Sekunden mit Flüssigkeit benetzt, die Flüssigkeitstemperatur beträgt am Anfang des Vorgangs 10 Sekunden lang 100°C und wird dann während 20 Sekunden kontinuierlich auf 195°C erhöht,
4. erwärmt sich auf annähernd 195°C, der Lötvorgang findet statt (ab 183°C) ,
5. wird anschließend 10 Sekunden mit Flüssigkeit mit einer Temperatur von 160°C benetzt, was dazu führt, daß die Baugruppentemperatur rasch unter den Schmelzpunkt des Lotes absinkt,
6. verläßt die Lötkammer mit einer Temperatur von ca. 165°C,
7. fährt in die Trockenkammer der Lötanlage (Umluft) und
8. verläßt die Lötanlage in trockenem Zustand.

Das Benetzen mit Flüssigkeit kann vorzugsweise im Sprühverfahren (Sprühlöten) erfolgen. Ein solches Sprühverfahren benutzt eine Vorrichtung, bei der eine oder mehrere Düsen gleichmäßig oberhalb oder unterhalb des Lötgutes angeordnet sind. Wahlweise kann durch Betätigen aller Düsen eine gleichmäßige Flächenbesprühung erfolgen. Eine selektive Erwärmung bestimmter Lötstellen wird erreicht, wenn nur einzelne Düsen oder Düsengruppen beim Sprühvorgang betätigt werden.

Das Verfahren kann über seine Verwendung als Lötverfahren hinaus auch überall dort eingesetzt werden, wo eine in einem weiten Bereich variable und/oder exakt kontrollierbare Verfahrenstemperatur benötigt wird, z.B. bei Bauelement-Burn-In, Trockungsprozessen usw.

## Patentansprüche

1. Verfahren zum Schwallöten von Lötgut, wie Leiterplatten bzw. Baugruppen in der Elektronik oder Metalle in der mechanischen Fertigung, **dadurch gekennzeichnet**, daß ein Teil der zum Löten erforderlichen Wärme einer Lötstelle mittels einer erwärmten Flüssigkeit durch Sprüchen zugeführt wird, die das Lötgut erwärmt, und daß die Temperatur der erwärmten Flüssigkeit nach einem vorgegebenen Temperaturprofil und/oder die Menge der versprühten Flüssigkeit zeitabhängig gesteuert wird.

2. Verfahren nach Anspruch 1, **dadurch gekennzeichnet**, daß die Menge der versprühten Flüssigkeit nach der Wärmekapazität der Lötstelle gesteuert wird.

3. Verfahren nach Anspruch 1 oder 2, **dadurch gekennzeichnet,** daß die erwärmte Flüssigkeit über das Lötgut hinwegfließt.

4. Verfahren nach einem der Ansprüche 1 bis 3, **dadurch gekennzeichnet,** daß die erwärmte Flüssigkeit die Lötstellen selektiv benetzt.

5. Verfahren nach einem der Ansprüche 1 bis 4, **dadurch gekennzeichnet**, daß die erwärmte Flüssigkeit chemisch inert ist.

6. Verfahren nach einem der Ansprüche 1 bis 5, **dadurch gekennzeichnet**, daß vor dem Lötvorgang die Lötstellen mittels der erwärmten Flüssigkeit bei niedrigerer Temperatur vorgeheizt werden.

7. Verfahren nach einem der Ansprüche 1 bis 6, wobei die Temperatur des Schwallotes etwa 190°C beträgt.

## Claims

1. A process for the flow soldering of parts, such as printed circuit boards or modules in the field of electronics, or metals in the field of mechanical manufacture, characterized in that part of the heat necessary for the soldering process is transferred to a soldering area by means of a heated liquid by a spraying process which heats up the parts, that the temperature of the heated liquid is controlled according to a predetermined temperature profile and/or the amount of the sprayed liquid is controlled time dependently.

2. The process according to claim 1, characterized in that the amount of the sprayed liquid is controlled according to the heat capacity of the soldering area.

3. The process according to claim 1 or 2, characterized in that the heated liquid flows over the parts.

4. The process according to any one of claims 1 to 3, characterized in that the heated liquid selectively moistens the soldering areas.

5. The process according to any one of claims 1 to 4, characterized in that the heated liquid is chemically inert.

6. The process according to any one of claims 1 to 5, characterized in that the soldering areas are preheated at a lower temperature by means of the heated liquid prior to the soldering process.

7. The process according to any one of claims 1 to 6, wherein the temperature of the flow solder is approximately 190°C.

## Revendications

1. Procédé pour le brasage tendre à la vague de produits à braser, tels que des plaquettes imprimées ou modules dans le domaine de l'électronique ou de métaux dans la fabrication mécanique, caractérisé en ce qu'une partie de la chaleur nécessaire pour le brasage d'un point de brasage est amenée par un liquide chauffé par pulvérisation, liquide qui réchauffe le produit à braser et en ce que la température du liquide réchauffé est contrôlée selon un profil de température prédonné et/ou en ce que la quantité du liquide pulvérisé est contrôlée en fonction du temps écoulé.

2. Procédé selon la revendication 1, caractérisé en ce que la quantité du liquide pulvérisé est contrôlée en fonction de la capacité thermique du point de brasage.

3. Procédé selon la revendication 1 ou 2, caractérisé en ce que le liquide réchauffé s'écoule sur le produit à braser.

4. Procédé selon l'une des revendications 1 à 3, caractérisé en ce que le liquide réchauffé mouille sélectivement les points de brasage.

5. Procédé selon l'une des revendications 1 à 4, caractérisé en ce que le liquide réchauffé est chimiquement inerte.

6. Procédé selon l'une des revendications 1 à 5, caractérisé en ce qu'avant l'opération de brasage, les points de brasage sont préchauffés au moyen du liquide réchauffé à température plus basse.

7. Procédé selon l'une des revendications 1 à 6, caractérisé en ce que la température du brasage tendre à la vague est sensiblement de 190°C.
